# EUROPEAN PATENT APPLICATION

(11) **EP 4 502 998 A1**
(43) Date of publication of application: **05.02.2025**
(21) Application number: 24190634.6
(22) Date of filing: 24.07.2024
(51) Int. Cl.: G09F 9/30, G06F 1/16

(54) **DISPLAY DEVICE AND MANUFACTURING METHOD FOR DISPLAY DEVICE**

(30) Priority: 31.07.2023 JP 2023124447
(71) Applicant: JDI Design & Development G.K., Tokyo 105-0003 (JP); TCL CHINA STAR OPTOELECTRONICS TECHNOLOGY CO., LTD., Shenzhen, Guangdong 518132 (CN)
(72) Inventor: SEKI, Takahiro, Tokyo, 105-0003 (JP)
(74) Representative: Murgitroyd & Company

(57) **Abstract**

A display device is provided in the present application, and includes a flexible display screen (25) and a plate-shaped back reinforcing member (40) attached to a back face of the flexible display screen. The back reinforcing member includes a surface (40a) facing the back face and an inner face (40b) facing away from the surface (40a), and includes first and second region portions (T1, T2) adjacent to each other in a first direction (d1) along the surface. When the back reinforcing member is viewed in section in a second direction (d1) along the surface (40a) and perpendicular to the first direction (d1), through hole(s) (41) through the back reinforcing member are provided in first region portion(s) (T1) in a third direction (d3) perpendicular to the first and second directions, and concave portion(s) (46) recessed from the surface toward the inner face are provided in the second region portion(s).

## Description

### TECHNICAL FIELD

The present disclosure relates to a display device with flexibility and a manufacturing method for the display device.

### BACKGROUND

Display devices having flexibility are well known in the art. As an example of such a display device, Patent Document 1 discloses a display device having a flexible display screen and a back reinforcing member attached to the flexible display screen. By forming a plurality of through holes (or slits) in the entire surface of the back reinforcing member, the back reinforcing member can be bent so as to wind around the display device.

### Prior art literature

### Patent document

[Patent Document 1] Patent No. US10798831

### SUMMARY

### Technical problem to be solved by the present application

However, the flexible display screen described in Patent Document 1 has a problem that the adhesion between the flexible display screen and the back reinforcing member is reduced due to through holes formed on the entire surface of the back reinforcing member.

The present application provides a display device capable of suppressing the decrease of adhesion between a flexible display screen and a back reinforcing member.

### Technical solution for solving technical problems

According to embodiments of the present application, it is provided a display device including a flexible display screen and a plate-shaped back reinforcing member attached to a back face of the flexible display screen; in which the back reinforcing member comprises a surface facing towards the back face of the flexible display screen and an inner face facing away from the surface, and the back reinforcing member comprises one or more first region portions and one or more second region portions that are adjacent to each other in a first direction that is along the surface; when the back reinforcing member is viewed in section in a second direction that is along the surface and perpendicular to the first direction, one or more through holes through the back reinforcing member are provided in the one or more first region portions in a third direction perpendicular to both the first direction and the second direction, and one or more concave portions recessed from the surface toward the inner face are provided in the one or more second region portions.

According to embodiments of the present application, it is provided a manufacturing method for a display device including a flexible display screen and a plate-shaped back reinforcing member attached to a back face of the flexible display screen, and the method includes a step of forming the back reinforcing member comprising one or more first region portions and one or more second region portions adjacent to each other in a first direction that is along a surface of a metal plate by etching the metal plate; a step of attaching the flexible display screen and the back reinforcing member; in which the step of forming the back reinforcing member comprises: forming a plurality of through holes in the one or more first region portions by half-etching the surface and an inner face of the metal plate, respectively, and forming a plurality of concave portions in the one or more second region portions by half-etching the surface of the metal plate.

### Beneficial effect

According to the display device or the like according to the present application, it is possible to suppress the decrease in adhesion between the flexible display screen and the back reinforcing member.

### BRIEF DESCRIPTION OF THE DRAWINGS

FIG. 1 is a schematic view of a display apparatus including a display device as viewed laterally.
FIG. 2 is a top view of a display device.
FIG. 3 is a cross-sectional view of display devices in both Comparative Example 1 and Comparative Example 2.
FIG. 4 is a top view of a back reinforcing member forming a part of the display device in Comparative Example 1.
FIG. 5 is a top view of a back reinforcing member forming a part of the display device in Comparative Example 2.
FIG. 6 is a schematic diagram of appearances of display devices in both Comparative Example 1 and Comparative Example 2.
FIG. 7 is a top view of a display device according to Embodiment 1.
FIG. 8 is a cross-sectional view of a display device according to Embodiment 1.
FIG. 9 is a top view of a back reinforcing member forming a part of a display device according to Embodiment 1.
FIG. 10 is an enlarged cross-sectional view of a back reinforcing member according to Embodiment 1 as laterally viewed.
FIG. 11 is a rear view of the back reinforcing member according to Embodiment 1.
FIG. 12 is a flowchart showing a manufacturing method for a display device according to Embodiment 1.
FIG. 13 is a view showing a manufacturing process of a back reinforcing member according to Embodiment 1.
FIG. 14 is a top view of a back reinforcing member forming a part of a display device according to Embodiment 2.
FIG. 15 is an enlarged cross-sectional view of a back reinforcing member according to Embodiment 2 as viewed from the side.
FIG. 16 is a rear view of the back reinforcing member according to Embodiment 2.
FIG. 17 is a schematic diagram showing a display apparatus including a display device according to Embodiment 3.
FIG. 18 is a cross-sectional view of a display device according to Embodiment 3.
FIG. 19 is a top view of a display device according to Embodiment 3.
FIG. 20 is a top view of a back reinforcing member forming a part of the display device according to Embodiment 3.
FIG. 21 is an enlarged cross-sectional view of the back reinforcing member in Embodiment 3 as viewed laterally.
FIG. 22 is a rear view of the back reinforcing member in Embodiment 3.
FIG. 23 is a top view of a back reinforcing member forming a part of the display device according to Embodiment 4.
FIG. 24 is an enlarged cross-sectional view of the back reinforcing member in Embodiment 4 as viewed laterally.
FIG. 25 is a rear view of the back reinforcing member in Embodiment 4.

### Reference signs:

1, 1B: display apparatus; 10, 10A, 10B, 10C: display device; 15b, 15C: curved portion; 20: display panel; 23: circular polarizer; 24: optical clear adhesive; 25: flexible display screen; 30: optical clear adhesive; 40, 40A, 40B, 40C: back reinforcing member; 40a: surface; 40b: inner face; 41: through hole; 42: inner groove portion; 42a: side surface; 42b: bottom surface; 46: concave portion; 46a: side surface; 46b: bottom surface; 51: front end; 52: display screen arrangement portion; 53: COF arrangement portion; 54: PCB arrangement portion; 60: back cover; 70: frame; 71: first frame portion; 72: second frame portion; 73: hinge; 75: adhesive; 81: pantograph; 83: COF; 84: PCB; 85: roller; 90: metal plate; 90a: surface; 90b: inner face; 91: resist; 91a: resist pattern layer; 92a, 92b: photomask; d1: first direction; d2: second direction; d3: third direction; T1: first region portion; T2: second region portion; L1, L2, L41, L46: length; and P41, p46, p416: distance.

### DETAILED DESCRIPTION

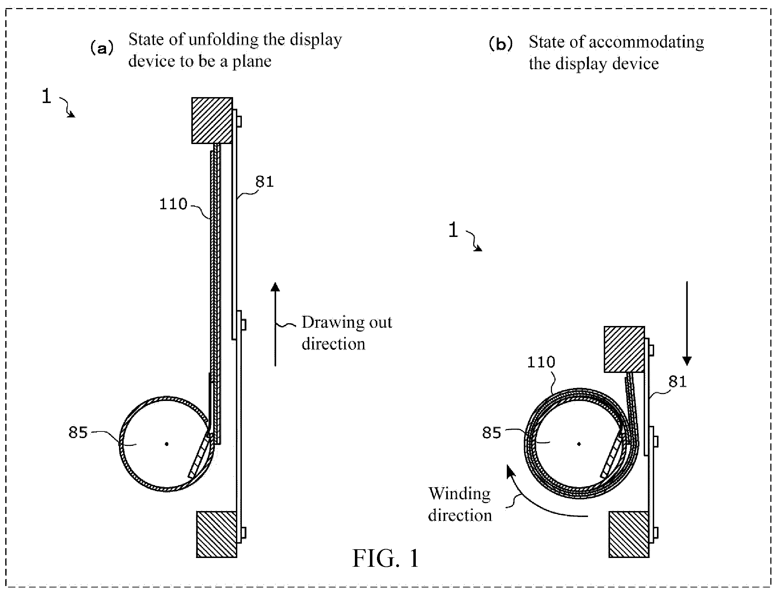

(Details of the present application) The details of the present application are described with reference to FIGS. 1 to 6.

First, the existing display device and the display apparatus including the display device will be described.

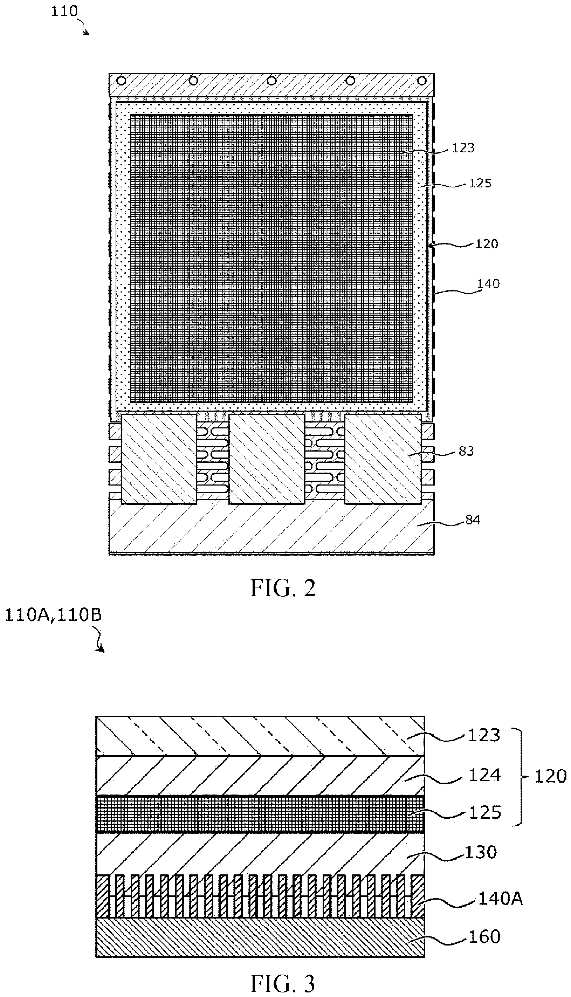

FIG. 1 is a schematic view of a display apparatus including a display device viewed from the side. FIG. 2 is a top view of the display device 110. FIG. 1 (a) shows a state in which the display device 110 having flexibility is unfolded in a plane, and FIG. 1 (b) shows a state in which the display device 110 is rolled up and accommodated.

The display apparatus 1 shown in FIG. 1 is an apparatus for displaying an image or the like. The display apparatus 1 includes a display device 110 having flexibility, and a pantograph 81 telescopically driven.

The display device 110 shown in FIG. 2 includes a display panel 120 having a circular polarizer 123 and a flexible display screen 125, a back reinforcing member 140 attached to the display panel 120, and a back cover (not shown) attached to the back reinforcing member 140. The display device 110 further includes an COF (Chip On Film) 83 as a flexible substrate, and a PCB (Printed Circuit Board) 84 as a driving substrate.

The display apparatus 1 is a rollable display apparatus for telescopically driving the pantograph 81 to pull out and roll up the display device 110 connected to the pantograph 81.

The display device 110 can be bent, and can be tightly accommodated by winding on the roller 85 (refer to (b) of FIG. 1). In addition, the display device 110 wound on the roller 85 is drawn out and thus the display device 110 is unfolded in a plane to be used as a display screen (refer to (a) of FIG. 1). In order to ensure the hardness of the display device 110, the back reinforcing member 140 is attached to the back face of the flexible display screen 125. A plurality of through holes (or slits) are formed in the back reinforcing member 140 so as to easily bend the back reinforcing member 140.

Herein, the display device 110A in Comparative Example 1 and the display device 110B in Comparative Example 2 will be described.

FIG. 3 is a cross-sectional view of the display devices in both Comparative Example 1 and Comparative Example 2.

As shown in FIG. 3, the display device 110A in Comparative Example 1 includes a circular polarizer 123, a flexible display screen 125, a back reinforcing member 140A, and a back cover 160. The circular polarizer 123 and the flexible display screen 125 are joined by an optical clear adhesive 124. The flexible display screen 125 and the back reinforcing member 140A are joined by an optical clear adhesive 130. A back cover 160 is attached to the inner face of the back reinforcing member 140A. The same is true for the display device 110B in Comparative Example 2.

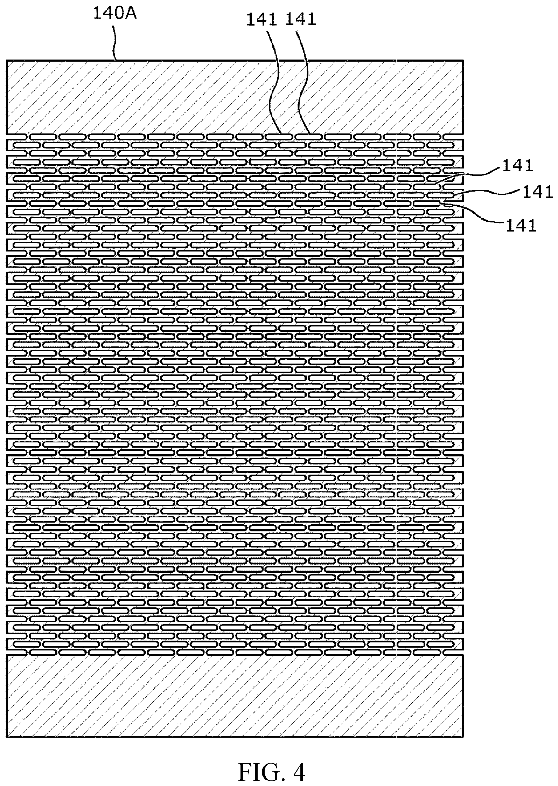

FIG. 4 is a top view of a back reinforcing member 140A forming a part of the display device 110A in Comparative Example 1. Further, in the top view described below, in order to make the through hole easily visible, shadow lines are marked on a region different from a region where the through holes are located.

As shown in FIG. 4, the back reinforcing member 140A in Comparative Example 1 has through holes 141 formed on the entire surface of the back reinforcing member 140A (the entire surface of the region in which the flexible display screen 125 is arranged). Therefore, there is a problem that the joint region between the flexible display screen 125 and the back reinforcing member 140A is reduced, and the adhesion between the flexible display screen 125 and the back reinforcing member 140A is reduced. For example, in the retractable display apparatus 1 subjected to repeated bending and stretching, there is a problem that the interface between the flexible display screen 125 and the back reinforcing member 140A is easily peeled off.

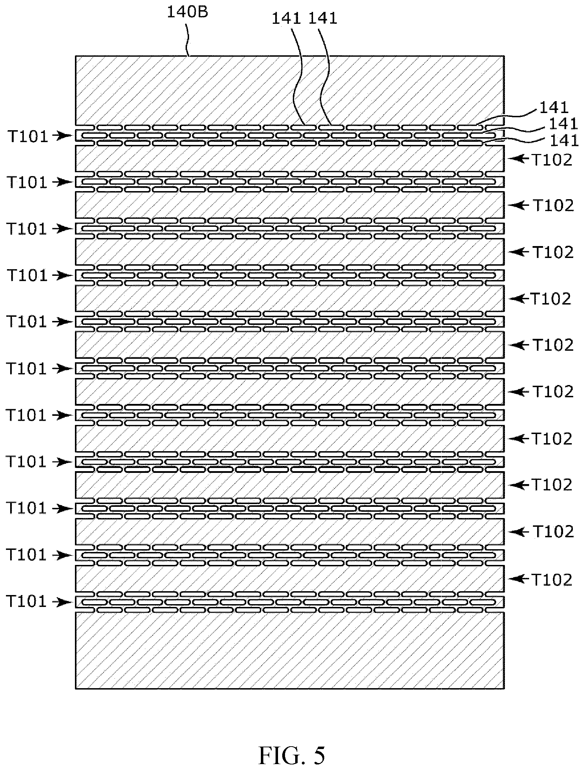

FIG. 5 is a top view of a back reinforcing member 140B forming a part of the display device 110B in Comparative Example 2.

The back reinforcing member 140B in Comparative Example 2 is not formed with the through holes 141 on the entire surface of the back reinforcing member 140B, but is provided with a region T101 in which the through holes 141 are formed and a region T102 in which the through holes 141 are not formed. The regions T101 and the regions T102 are alternately arranged in a direction of drawing out the display device 110B or in a direction of winding the display device 110B (refer to FIG. 1).

As shown in Comparative Example 2, by providing the region T102 in which the through holes 141 are not formed, it is possible to suppress the adhesion reduction between the flexible display screen 125 and the back reinforcing member 140B. However, in the configuration in Comparative Example 2, there is another problem that the appearance of the display device 110B deteriorates.

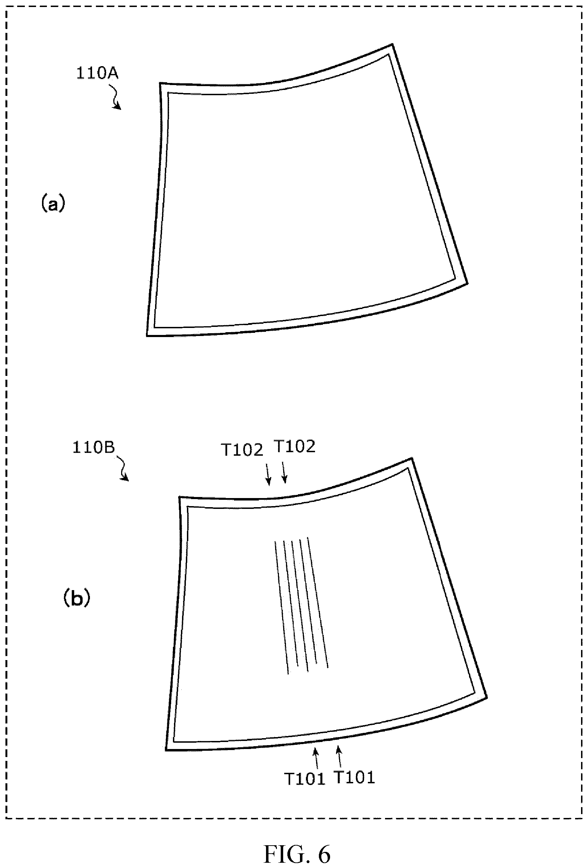

FIG. 6 is a schematic diagram of the appearances of the display devices in both Comparative Example 1 and Comparative Example 2. (a) of FIG. 6 shows the appearance of the display device 110A in Comparative Example 1, and (b) of FIG. 6 shows the appearance of the display device 110B in Comparative Example 2. These figures show a state in which the display device is not driven, i.e., a state in which no image is displayed on the flexible display screen 125.

In the display device 110A of Comparative Example 1 shown in (a) of FIG. 6, since the entire surface of the back reinforcing member 140A is regularly formed with a plurality of through holes 141, even if the display device 110A is bent, there is no appearance problem. However, in the display device 110B of Comparative Example 2 shown in (b) of FIG. 6, as described above, since there are the region T101 in which the through holes 141 are formed and the region T102 in which the through holes 141 are not formed, when the display device 110B is bent, the degree of bending of the back reinforcing member 140B becomes different in the region T101 and the region T102. Therefore, there is a problem in that the appearance of the display device 110B deteriorates.

In this regard, the display device of the present application has the structure described below in order to prevent the adhesion between the flexible display screen and the back reinforcing member from being reduced, and to prevent appearance deterioration.

An embodiment of a display device related to the present application is described below with reference to the accompanying drawings. It should be noted that the embodiments described below are one specific example of the present application. Accordingly, the numerical values, the structural elements, the configuration positions of the structural elements, the connection manner, and the like shown in the following embodiments are exemplary and are not intended to limit the contents of the present application. Therefore, in the structural elements of the following embodiments, the structural elements not described in the independent claims are interpreted as arbitrary structural elements.

In the drawings, substantially identical structural elements are denoted by the same reference numerals. In addition, the drawings are diagrammatic, and do not strictly indicate the size ratios of the parts.

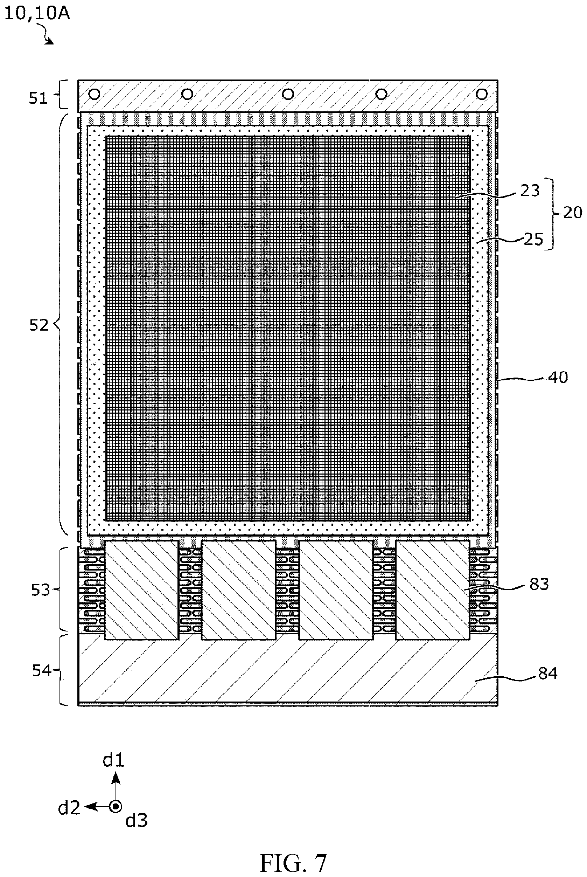

(Embodiment 1) [Configuration of Display device] The configuration of the display device according to Embodiment 1 will be described with reference to FIGS. 7 to 11.

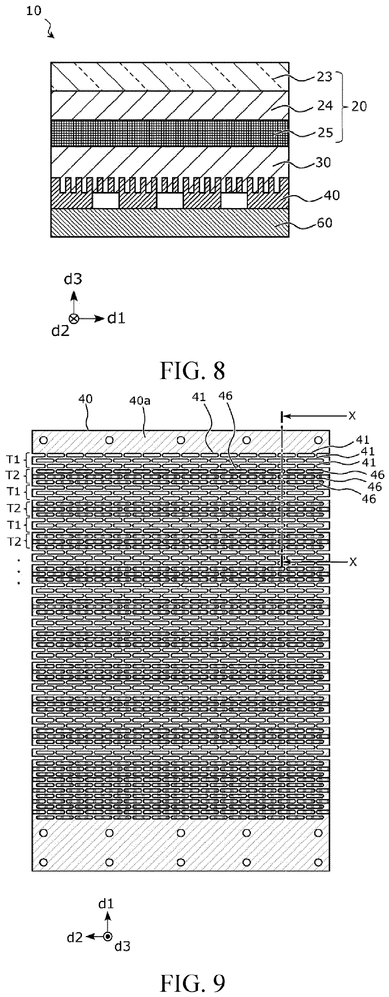

FIG. 7 is a top view of a display device 10 according to Embodiment 1. FIG. 8 is a cross-sectional view of the display device 10.

The display device 10 shown in FIG. 7 is a sheet-like apparatus for displaying the image. The display device 10 is used, for example, for a tablet terminal, a digital television, a digital signage, a smartphone, a wearable terminal, or the like.

As shown in FIG. 8, the display device 10 includes a display panel 20 having flexibility, a back reinforcing member 40, and a back cover 60.

The display panel 20 is connected to a PCB 84 as a driving substrate by a COF 83 as a flexible substrate (see FIG. 7), and is driven by the PCB 84 to display the image.

The display panel 20 is composed of a circular polarizer 23 and a flexible display screen 25 attached to the back face of the circular polarizer 23. The circular polarizer 23 and the flexible display screen 25 are joined by an OCA (Optical Clear Adhesive) 24. The flexible display screen 25 is formed by laminating a TFT (thin film transistor), an OLED (Organic Light Emitting Diode) panel having an organic EL (Electro-Luminescence) element, and a TFE (Thin Film Encapsulation). In FIG. 8, the circular polarizer 23 is located on the uppermost surface, but is not limited thereto. A covering window may be provided above the circular polarizer 23, and the covering window and the circular polarizer 23 may be joined by an optical clear adhesive.

The back reinforcing member 40 is a plate-shaped member for reinforcing the hardness of the display panel 20. The back reinforcing member 40 is attached to an inner face of the display panel 20, that is, the back face of the flexible display screen 25. The flexible display screen 25 and the back reinforcing member 40 are joined by an optical clear adhesive 30. The back reinforcing member 40 has flexibility and elasticity, and can be bent and deformed by application of an external force. Stainless steel or Invar steel material (a low-expansion metal containing 36% nickel in iron) may be used as the material of the back reinforcing member 40. For example, the thickness of the back reinforcing member 40 may be appropriately selected from a range of 0.1 mm or more and 0.3 mm or less.

The back cover 60 is a member covering the back face of the back reinforcing member 40, and is attached to the back face of the back reinforcing member 40. The back cover 60 is joined to the back reinforcing member 40 by an adhesive layer formed on the surface. The back cover 60 is flexible and can be bent and deformed by application of an external force.

The display device 10 is wound on the roller 85 of the display apparatus 1, and is drawn out from the wound state so as to be unwound to be a plane shape.

In this case, as shown in FIG. 7, in a state in which the display device 10 is unfolded to be a plane shape, a direction that is along the display surface of the display device 10 and drawing the display device 10 out of the display apparatus 1 is referred to as the first direction d1; a direction that is along the display surface of the display device 10 and perpendicular to the first direction d1 is referred to as the second direction d2; and a direction perpendicular to both the first direction d1 and the second direction d2 is referred to as the third direction d3. The third direction d3 is the same as the thickness direction of the display device 10.

For example, the display device 10 is rectangular in shape when viewed from the third direction d3 in a state in which the display device 10 is unfolded to be a plane shape. A side (a positive side of the Z-axis direction) of the display device 10 which faces towards the third direction d3 displays the image. Then, the display device 10 is rotated by centering an axis extending in the second direction d2 by the roller 85 of the display apparatus 1, and wound around the roller 85. The display device 10 is wound so that the back reinforcing member 40 and the back cover 60 are located outside the display panel 20.

The back reinforcing member 40 shown in FIG. 7 includes a front end portion 51 connected to a front end of the pantograph 81, a display screen arrangement portion 52 provided with a flexible display screen 25, a COF arrangement portion 53 provided with a COF 83, and a PCB arrangement portion 54 provided with a PCB 84. Among the front end portion 51, the display screen arrangement portion 52, the COF arrangement portion 53, and the PCB arrangement portion 54, the display screen arrangement portion 52 is a portion specifically related to the adhesion of the flexible display screen 25 and the appearance of the display device 10. The structure of the back reinforcing member 40 in the display screen arrangement portion 52 will be described below.

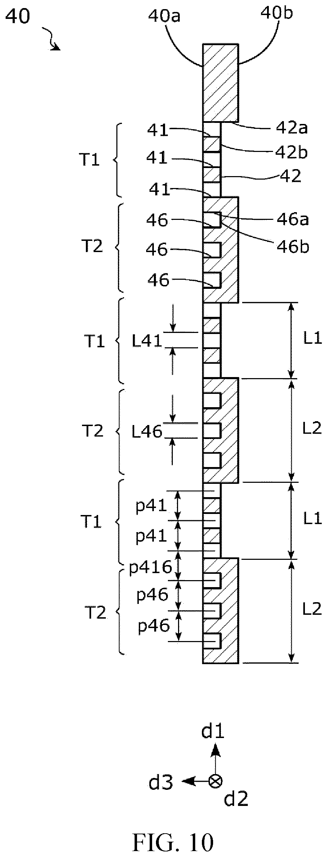

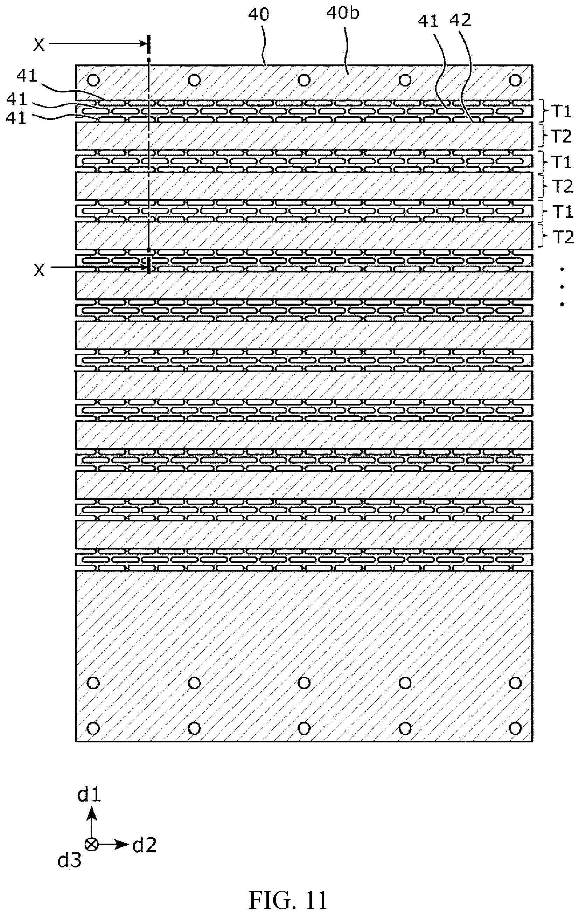

FIG. 9 is a top view of the back reinforcing member 40 forming a part of the display device 10. FIG. 10 is an enlarged cross-sectional view of the back reinforcing member 40 viewed from the side. FIG. 11 is a rear view of the back reinforcing member 40. FIG. 10 shows a cross section taken along line X-X in FIG. 9.

The back reinforcing member 40 has a surface 40a facing towards the back face of the flexible display screen 25, and an inner face 40b facing away from the surface 40a. And, the back reinforcing member 40 has first region portion(s) T1 and second region portion(s) T2 adjacent to each other in a first direction d1 that is along the surface 40a.

The first region portion(s) T1 include multiple first region portions in back reinforcing member 40, and the second region portion(s) include multiple second region portions in the back reinforcing member 40. The multiple first region portions and the multiple second region portions are arranged alternately in the first direction d1. In the example shown in FIGS. 9 and 11, it is provided ten first region portions T1 and nine second region portions T2 in the display screen arrangement portion 52.

The first region portion T1 and the second region portion T2 are provided along the second direction d2, respectively. Each of the first region portion T1 and the second region portion T2 in the second direction d2 has the same length as the length of the back reinforcing member 40 in the second direction d2.

As shown in FIG. 10, one inner groove portion 42 and the through holes 41 are formed in the first region portion T1.

The inner groove portion 42 is formed to be recessed from the inner face 40b toward the surface 40a. The inner groove portion 42 is extended in the second direction d2 in the inner face 40b of the back reinforcing member 40 (see FIG. 11). The length of the inner groove portion 42 in the second direction d2 is the same as the length of the back reinforcing member 40 in the second direction d2.

The inner groove portion 42 has a side surface 42a extending from the inner face 40b toward the surface 40a, and a bottom surface 42b more adjacent to the surface 40a with respect to the inner face 40b and connected to the side surface 42a. A depth from the inner face 40b to the bottom surface 42b is about half of a thickness of the back reinforcing member 40. The inner groove portion 42 is formed, for example, by half-etching a metal plate serving as a material of the back reinforcing member 40 from a side where the inner face is located.

Multiple through holes 41 are formed to penetrate through the surface 40a in the first region portion T1 and the bottom surface 42b of the inner groove portion 42, respectively.

As shown in FIGS. 9 and 11, the multiple through holes 41 each have a long-hole shape having a width in the first direction d1 and a length in the second direction d2. The length of the through hole 41 in the second direction d2 is shorter than the length of the back reinforcing member 40 in the second direction d2. For example, the length of the through hole 41 in the second direction d2 is not less than 1/20 and not more than 1/5 of the length of the back reinforcing member 40 in the second direction d2. The through hole 41 may be rectangular in shape or may be elliptical in shape. The through hole 41 is formed by half-etching a metal plate serving as a material of the back reinforcing member 40 from two sides where the surface and the inner face are located.

When the back reinforcing member 40 is viewed from the third direction d3 perpendicular to the surface 40a, the multiple through holes 41 are arranged in a staggered manner in the first region portion T1. In other words, when viewed from the first direction d1, the multiple through holes 41 are formed so that adjacent two through holes 41 in the first direction d1 are partially overlapped. The multiple through holes 41 are arranged in a staggered manner, so that the distance between the thick metal portions continuous in the first direction d1 can be made shorter, and the first region portion T1 can be made flexible.

As shown in FIG. 10, when the back reinforcing member 40 is viewed along the second direction d2 that is along the surface 40a of the back reinforcing member 40 and perpendicular to the first direction d1, the multiple through holes 41 pass through the back reinforcing member 40 in the third direction d3 perpendicular to both the first direction d1 and the second direction d2. In this example, three through holes 41 are formed in the first region portion T1 in the first direction d 1.

As shown in FIG. 10, the length L1 of the bottom surface 42b of the inner groove portion 42 in the first direction d1 is longer than the length (the hole width) L41 of the through hole 41 in the first direction d1 (L1>L41). Moreover, the length L1 is longer than the distance p41 between the two adjacent through holes 41 in the first direction d1 (L1>p41).

As shown in FIG. 10, multiple concave portions 46 are provided in the second region portion T2. The multiple concave portions 46 are formed on the surface 40a of the back reinforcing member 40.

The concave portion 46 has a side surface 46a extending from the surface 40a toward the inner face 40b, and a bottom surface 46b located more adjacent to the inner face 40b with respect to the surface 40a and connected to the side surface 46a. The depth from the surface 40a to the bottom surface 46b is about half of the thickness of the back reinforcing member 40. The concave portion 46 is formed, for example, by half-etching a metal plate serving as a material of the back reinforcing member 40 from the side where the surface is located.

As shown in FIG. 9, the multiple concave portions 46 each have a long-hole shape with a width in the first direction d1 and a length in the second direction d2. In FIG. 9, a partial region of the concave portion 46 is shown by using shadow dots. The length of the concave portion 46 in the second direction d2 is shorter than the length of the back reinforcing member 40 in the second direction d2. For example, the length of the concave portion 46 in the second direction d2 is not less than 1/20 and not more than 1/5 of the length of the back reinforcing member 40 in the second direction d2. The concave portion 46 may be rectangular in shape or oval in shape. It should be noted that in the present embodiment, the concave portion 46 and the through hole 41 have the same long-hole shape with the width in the first direction d1 and the length in the second direction d2. The widths of both the concave portion 46 and the through hole 41 in the first direction dl are, for example, the same as the thickness of the back reinforcing member 40.

When the back reinforcing member 40 is viewed in the third direction d3, the multiple concave portions 46 are arranged in a staggered manner in the second region portion T2. In other words, when viewed in the first direction d1, the multiple concave portions 46 are formed such that two adjacent concave portions 46 are partially overlapped in the first direction d1. By arranging the multiple concave portions 46 in a staggered manner, the distance between the continuous thick metal portions in the first direction d1 is shortened, and the second region portion T2 has flexibility.

As shown in FIG. 10, when the back reinforcing member 40 is viewed from the second direction d2, the multiple concave portions 46 are formed to be recessed from the surface 40a of the back reinforcing member 40 toward the inner surface 40b. In this example, three concave portions 46 are formed in the second region portion T2 in the first direction d1.

As shown in FIG. 10, the length L2, which is in the first direction d1, of an inner face of one second region portion T2 of the inner face 40b is longer than the length (the hole width) L46 of the concave portion 46 in the first direction d1 (L2>L46). The above length L2 is longer than the distance p46 between the two adjacent concave portions 46 in the first direction d1 (L2>p46).

In the present embodiment, the distance p41 between the two adjacent through holes 41 in the first direction d1, the distance p46 between the two concave portions 46, and the distance p416 between the through hole 41 and the concave portion 46 are the same. It should be noted that the distance p41 is a distance between centers of these two adjacent through holes 41, the distance p46 is a distance between centers of these two concave portions 46, and the distance p416 is a distance between centers of the through hole 41 and the concave portion 46, respectively.

As described above, the display device 10 according to the present embodiment includes a flexible display screen 25, and a plate-shaped back reinforcing member 40 attached to the back face of the flexible display screen 25. The back reinforcing member 40 has a surface 40a facing the back face of the flexible display screen 25, and an inner face 40b facing away from the surface 40a. And, the back reinforcing member 40 has a first region portion T1 and a second region portion T2 adjacent to each other in a first direction d1 that is along the surface 40a. When the back reinforcing member 40 is viewed from the second direction d2, the first region portion T1 is provided with a through hole 41 through the back reinforcing member 40 in the third direction d3. The second region portion T2 is provided with a concave portion 46 recessed from the surface 40a toward the inner face 40b.

Thus, by providing the concave portion 46 in the second region T2 of the back reinforcing member 40, when the back reinforcing member 40 is attached to the flexible display screen 25, a portion of the optical clear adhesive 30 can be brought into contact with the inner face of the concave portion 46 (see FIG. 8). As a result, it is possible to prevent the adhesion between the flexible display screen 25 and the back reinforcing member 40 from being reduced. Further, by providing the concave portion 46 in the second region portion T2, the degree of curvature in the second region portion T2 can be made close to the degree of curvature in the first region portion T1, and deterioration of the appearance of the display device 10 can be suppressed.

Further, in the present embodiment, the first region portion T1 is provided with an inner groove portion 42 recessed from the inner face 40b toward the surface 40a, and the length L1 of the bottom surface 42b of the inner groove portion 42 in the first direction d1 is longer than the length L41 of the through hole 41 in the first direction d1.

Accordingly, for example, when the metal plate serving as the material of the back reinforcing member 40 is half-etched from two sides where the surface and the inner face are located, the through holes 41 and the inner groove portions 42 may be connected even if the through holes 41 and the inner groove portions 42 are slightly staggered in the first direction d1. As a result, it is possible to prevent the holes that should penetrate through the first region portion T1 from becoming non-penetrable, and to ensure the flexibility of the back reinforcing member 40 in the first region portion T1.

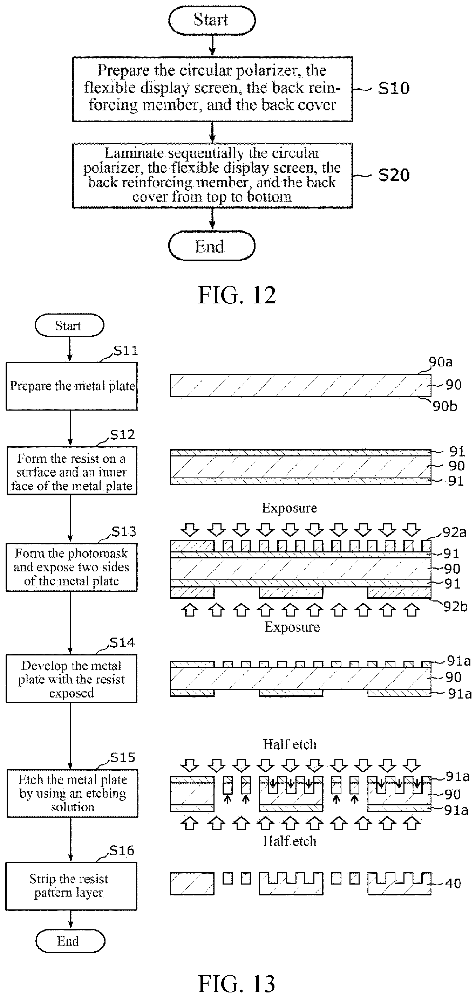

[Manufacturing method for the display device] The manufacturing method for a display device according to Embodiment 1 will be described with reference to FIGS. 12 and 13.

FIG. 12 is a flowchart showing a manufacturing method for a display device 10 according to Embodiment 1.

First, components for manufacturing the display device 10 are prepared. Specifically, the circular polarizer 23, the flexible display screen 25, the back reinforcing member 40, and the back cover 60 are prepared (at step S10). Next, the circular polarizer 23, the flexible display screen 25, the back reinforcing member 40, and the back cover 60 are sequentially laminated from top to bottom (at step S20). The display device 10 is manufactured by these steps S10 and S20.

It should be noted that the back reinforcing member 40 is manufactured by the manufacturing process described below.

FIG. 13 is a view showing a manufacturing process for the back reinforcing member 40 according to Embodiment 1.

First, a metal plate 90 as a processed material is prepared (at step S11). A material such as stainless steel or Invar steel may be used as the metal plate 90. At step S11, the metal plate 90 is cleaned and then prepared.

Next, the resist 91 is formed on a surface 90a and an inner face 90b of the metal plate 90, respectively (at step S12). The resist 91 forms a uniform resist film over the entire surface 90a and the entire inner face90b.

Next, a photomask having a predetermined pattern shape is formed on two sides of the metal plate 90 which are formed with resist 91, and two sides of the metal plate 90 are exposed (at step S13). Note that the photomask 92a on the surface 90a of the metal plate 90 is formed so that openings are provided at positions corresponding to the through holes 41 and the concave portions 46, and a light shielding film is provided at another position different from the through holes 41 and the concave portions 46. The photomask 92b on the inner face 90b of the metal plate 90 is formed such that openings are provided at positions corresponding to the inner groove portions 42, and a light shielding film is provided at another position different from the inner groove portions 42. In the exposed region of the resist 91, a modified layer of the resist is formed.

Next, the metal plate 90 with the resist 91 exposed is developed (at step S14). By this development, the modified layer of the resist is removed, and the resist pattern layer 91a having a predetermined pattern shape is formed on two sides of the metal plate 90.

Next, the metal plate 90 with the resist pattern layer 91a is etched by using an etching solution (at step S15). At this time, the metal plate 90 is half-etched from two sides where the surface 90a and the inner face 90b of the metal plate 90 are located. By the half-etching, the inner groove portions 42, the through holes 41, and the concave portions 46 are formed. It should be noted that a portion of the through hole 41 overlaps the inner groove portion 42 and is formed at the same time as the inner groove portion 42.

Next, the resist pattern layer 91a is stripped from the etched metal plate 90 (at step S16). The region in which the inner groove portion 42 is formed becomes the first region portion T1, and the region in which the inner groove portion 42 is not formed becomes the second region portion T2.

The back reinforcing member 40 is manufactured by performing these steps S11 to S16. Specifically, a back reinforcing member 40 including a first region portion T1 including an inner groove portion 42 and a through hole 41, and a second region portion T2 including a recess portion 46 is manufactured.

By the above-described manufacturing method, it is possible to manufacture the display device 10 capable of suppressing the decrease in adhesion between the flexible display screen 25 and the back reinforcing member 40. Further, the display device 10 can be manufactured to suppress deterioration of appearance.

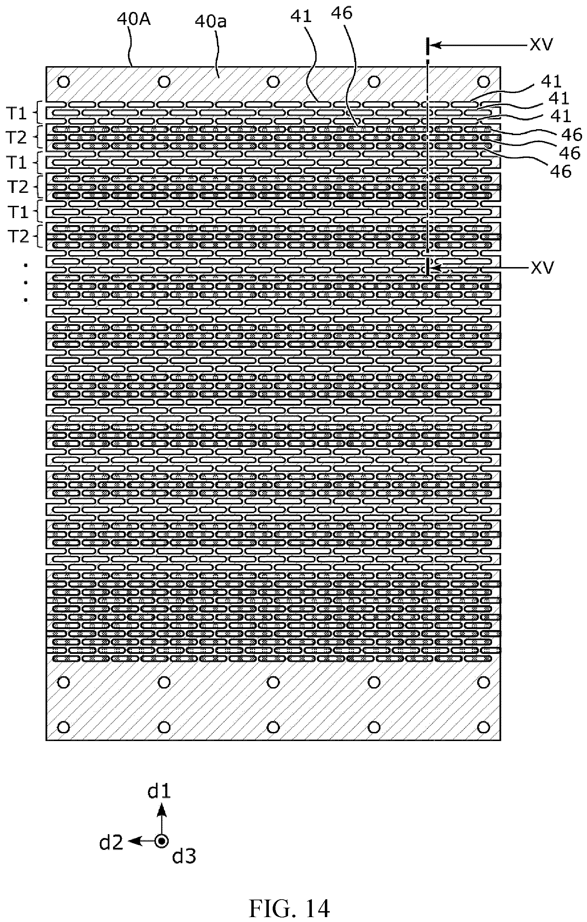

(Embodiment 2) The configuration of the display device 10A according to Embodiment 2 will be described with reference to FIGS. 14 to 16. In the display device 10A according to Embodiment 2, through holes 41 are provided in the first region portion T1, and an example in which the inner groove portion 42 is not provided will be described.

The display device 10A of Embodiment 2 includes a display panel 20 having flexibility, a back reinforcing member 40A, and a back cover 60.

The display panel 20 is connected to the PCB 84 as a driving substrate through the COF 83 as a flexible substrate, and is driven by the PCB 84 to display an image.

The display panel 20 includes a circular polarizer 23 and a flexible display screen 25 attached to the back face of the circular polarizer 23. The circular polarizer 23 and the flexible display screen 25 are joined by an optical clear adhesive 24.

The back reinforcing member 40A is attached to the back face of the display panel 20, that is, the back face of the flexible display screen 25. The flexible display screen 25 and the back reinforcing member 40A are joined by an optical clear adhesive 30. The back reinforcing member 40A has flexibility and elasticity, and can be bent and deformed by application of an external force. Stainless steel or Invar steel material may be used as the material of the back reinforcing member 40A. The thickness of the back reinforcing member 40A may be appropriately selected from a range of, for example, 0.1 mm or more and 0.3 mm or less.

The back cover 60 is a member that covers the back face of the back reinforcing member 40A and attached to the back face of the back reinforcing member 40A. The back cover 60 is joined to the back reinforcing member 40A by an adhesive layer formed on the surface. The back cover 60 is flexible and can be bent and deformed by application of an external force.

The back reinforcing member 40A includes a front end portion 51 connected to a front end portion of the pantograph 81, a display screen arrangement portion 52 in which the flexible display screen 25 is arranged, a COF arrangement portion 53 in which the COF 83 is arranged, and a PCB arrangement portion 54 in which the PCB 84 is arranged. The structure of the back reinforcing member 40A in the display screen arrangement portion 52 will be described as an example.

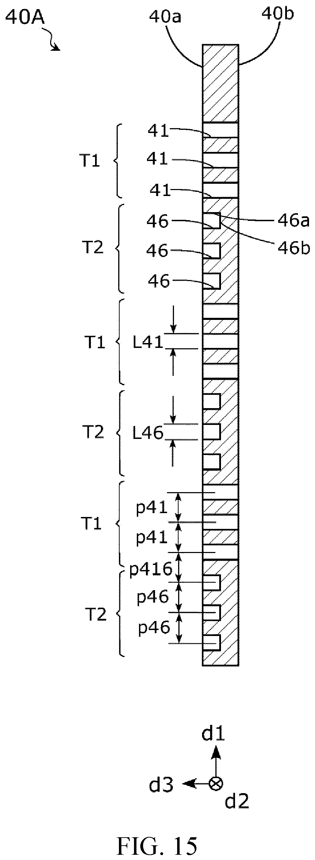

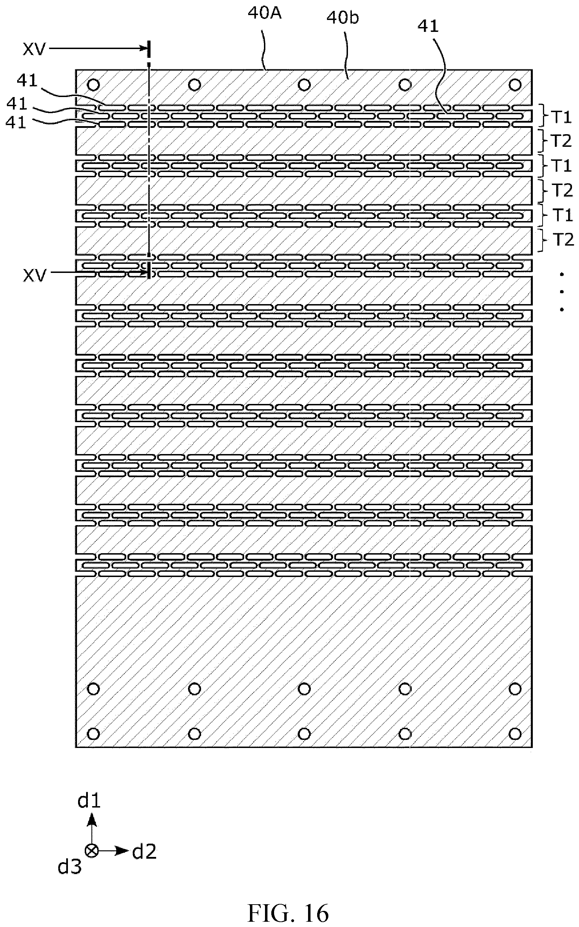

FIG. 14 is a top view of a back reinforcing member 40A forming a part of the display device 10A according to Embodiment 2. FIG. 15 is an enlarged sectional view of the back reinforcing member 40A viewed from the side. FIG. 16 is a rear view of the back reinforcing member 40A. FIG. 15 shows a cross section taken along line XV-XV in FIG. 14.

The back reinforcing member 40A has a surface 40a facing the back face of the flexible display screen 25, and an inner face 40b facing away from the surface 40a. And, the back reinforcing member 40A includes first region portion(s) T1 and second region portion(s) T2 adjacent to each other in the first direction d1 that is along the surface 40a.

The first region portion(s) T1 include multiple first region portions and the second region portion(s) T2 include multiple second region portions in the back reinforcing members 40A. The multiple first region portions and the multiple second region portions are arranged alternately in the first direction d1. In the example shown in FIGS. 14 and 16, it is provided ten first region portions T1 and nine second region portions T2 in the display screen arrangement portion 52.

The first region portion T1 and the second region portion T2 are provided along the second direction d2, respectively. Each of the first region portion T1 and the second region portion T2 has the same length in the second direction d2 as the length of the back reinforcing member 40Ain the second direction d2.

As shown in FIG. 15, a plurality of through holes 41 are formed in the first region portion T1.

The plurality of through holes 41 are formed to pass through the surface 40a and the inner face 40b in the first region portion T1, respectively.

As shown in FIGS. 14 and 16, the plurality of through holes 41 each have a long-hole shape having a width in the first direction d1 and a length in the second direction d2. The length of the through hole 41 in the second direction d2 is shorter than the length of the back reinforcing member 40A in the second direction d2. The through hole 41 may be rectangular in shape or may be elliptical in shape. The through hole 41 is formed by half-etching a metal plate serving as a material of the back reinforcing member 40A from two sides where the surface and the inner face are located.

When the back reinforcing member 40A is viewed from the third direction d3 perpendicular to the surface 40a, the plurality of through holes 41 are arranged in a staggered manner in the first region portion T1. In other words, when the plurality of through holes 41 are viewed from the first direction d1, adjacent two through holes 41 in the first direction d1 are partially overlapped. The plurality of through holes 41 are arranged in a staggered manner, so that the distance between the thick metal portions continuous in the first direction d1 is shortened, and the first region portion T1 has flexibility.

As shown in FIG. 15, when the back reinforcing member 40A is viewed from the second direction d2, the plurality of through holes 41 pass through the back reinforcing member 40A in the third direction d3. In this example, three through holes 41 are formed in the first region portion T1 in the first direction d1.

As shown in FIG. 15, a plurality of concave portions 46 are provided in the second region portion T2. A plurality of concave portions 46 are formed on the surface 40a of the back reinforcing member 40A.

The concave portion 46 has a side surface 46a extending from the surface 40a toward the inner face 40b, and a bottom surface 46b located more adjacent to the inner face 40b with respect to the surface 40a and connected to the side surface 46a. The depth from the surface 40a to the bottom surface 46b is about half the thickness of the back reinforcing member 40A. The concave portion 46 is formed, for example, by half-etching a metal plate serving as a material of the back reinforcing member 40A from a side where the surface is located.

As shown in FIG. 14, the plurality of concave portions 46 each have a long-hole shape having a width in the first direction d1 and a length in the second direction d2. A portion of the region of the concave portion 46 is shown by using shadow dots in Fig. 14. The length of the concave portion 46 in the second direction d2 is shorter than the length of the back reinforcing member 40A in the second direction d2. The concave portion 46 may be rectangular in shape or oval in shape. It should be noted that in the present embodiment, the concave portion 46 and the through hole 41 have the same long-hole shape with the width in the first direction d1 and the length in the second direction d2.

When the back reinforcing member 40A is viewed from the third direction d3, the plurality of concave portions 46 are arranged in a staggered manner in the second region portion T2. In other words, when the plurality of concave portions 46 are viewed from the first direction d1, two adjacent concave portions 46 in the first direction d1 are partially overlapped. By arranging the plurality of concave portions 46 in a staggered manner, the distance between the thick metal portions continuous in the first direction d1 is shortened, and the second region portion T2 has flexibility.

As shown in FIG. 15, when the back reinforcing member 40A is viewed from the second direction d2, the plurality of concave portions 46 are formed to be recessed from the surface 40a toward the inner face 40b of the back reinforcing member 40A. In this example, three concave portions 46 are formed in the second region portion T2 in the first direction d1. The distance p41 between the two adjacent through holes 41 in the first direction d1, the distance p46 between the two concave portions 46, and the distance p416 between the through holes 41 and the concave portions 46 are the same.

As shown in the present embodiment, when the back reinforcing member 40A is attached to the flexible display screen 25 by providing the concave portion 46 in the second region T2 of the back reinforcing member 40A, a portion of the optical clear adhesive 30 can be brought into contact with the inner face of the concave portion 46. As a result, it is possible to prevent the adhesion between the flexible display screen 25 and the back reinforcing member 40A from being reduced. Further, by providing the concave portion 46 in the second region portion T2, the degree of curvature in the second region portion T2 and the degree of curvature in the first region portion T1 can be made close to each other, and deterioration of the appearance of the display device 10A can be suppressed.

In Embodiment 2, since the inner groove portion 42 is not formed in the first region portion T1, the thick wall of the region other than the through holes 41 in the first region portion T1 can be made thicker. Thus, compared with Embodiment 1, the hardness of the back reinforcing member 40A in the first region portion T1 can be improved.

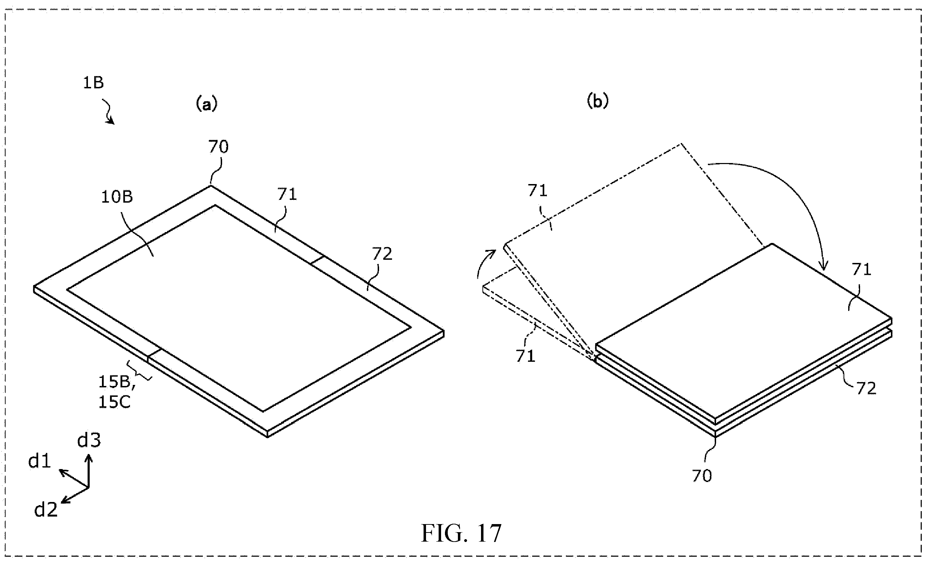

(Embodiment 3) A display device 10B according to Embodiment 3 will be described with reference to FIGS. 17 to FIG. 22. In Embodiment 3, the display apparatus 1B including the display device 10B is described as a foldable device by way of example.

FIG. 17 is an oblique view of the display apparatus 1B including the display device 10B in accordance with Embodiment 3.

The display apparatus 1B is a device for displaying an image or the like, and can be folded. The display apparatus 1B is a flat panel terminal capable of folding. The display apparatus 1B may be a digital television, a digital signage, a smart phone, a wearable terminal, or the like.

As shown in (a) of FIG. 17, the display device 10B has a foldable structure in the curved portion 15B located at the center in the first direction d1. By folding the display device 10B at the curved portion 15B, as shown in (b) of FIG. 17, the display device 10B can be folded in half.

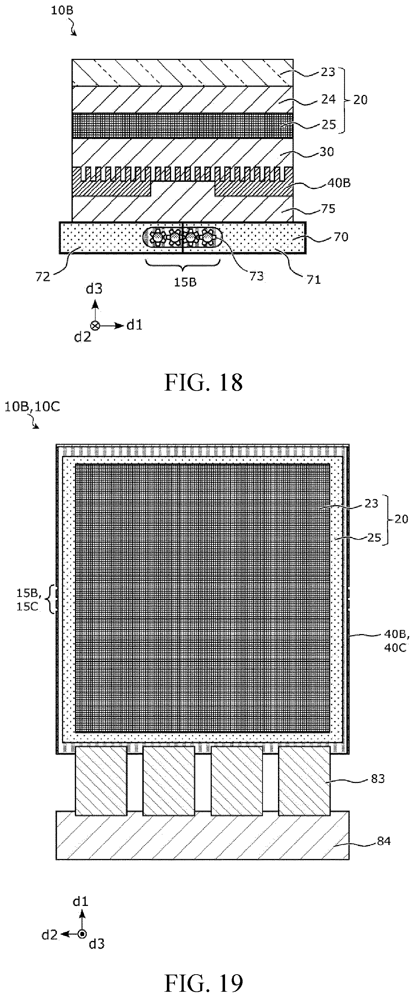

FIG. 18 is a cross-sectional view of the display device 10B. FIG. 19 is a top view of the display device 10B.

As shown in FIG. 18, the display device 10B includes a display panel 20, a back reinforcing member 40B, and a frame 70. The display panel 20 is connected to the PCB 84 (referring to FIG. 19) as a driving substrate through the COF 83 as a flexible substrate, and is driven by the PCB 84 to display an image.

As shown in FIG. 18, the display panel 20 includes a circular polarizer 23 and a flexible display screen 25 attached to the back face of the circular polarizer 23. The circular polarizer 23 and the flexible display screen 25 are joined by an optical clear adhesive 24.

The back reinforcing member 40B is attached to the back face of the display panel 20, that is, the back face of the flexible display screen 25. The flexible display screen 25 and the back reinforcing member 40B are joined by an optical clear adhesive 30. The back reinforcing member 40B has flexibility and elasticity, and can be bent and deformed by application of an external force. A material such as stainless steel or Invar steel may be used as the material of the back reinforcing member 40B. The thickness of the back reinforcing member 40B may be appropriately selected from a range of, for example, 0.1 mm or more and 0.3 mm or less.

The frame 70 is joined to the back reinforcing member 40B by an adhesive 75. The frame 70 includes a first frame portion 71, a second frame portion 72, and a hinge 73. The first frame portion 71 is connected to a part of the back reinforcing member 40B, and the second frame portion 72 is connected to another part of the back reinforcing member 40B.

When the first frame portion 71 and the second frame portion 72 are viewed from the third direction d3 in an unfolded state of the display device 10B, the first frame portion 71 and the second frame portion 72 are arranged in the first direction d1. The first frame portion 71 and the second frame portion 72 are rotatably connected together by the hinge 73. By rotating one of the first frame portion 71 and the second frame portion 72 with respect to the other, the frame 70 can be bent and folded (see (b) of FIG. 17). By folding the frame 70, the display panel 20, the back reinforcing member 40B, and the like are also folded.

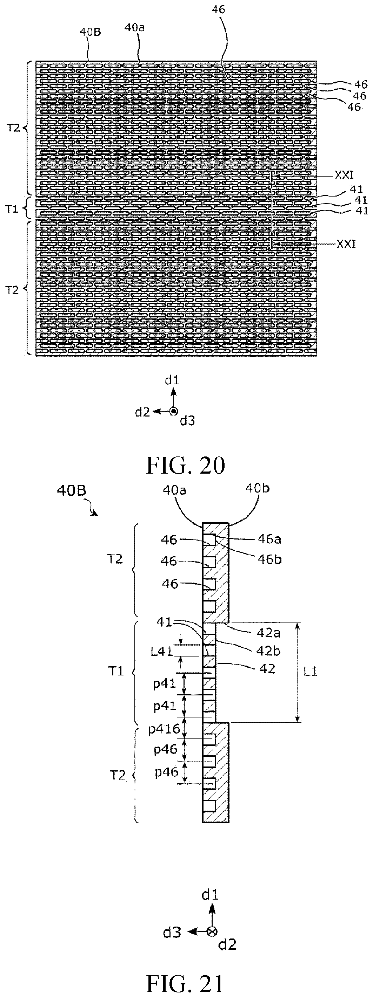

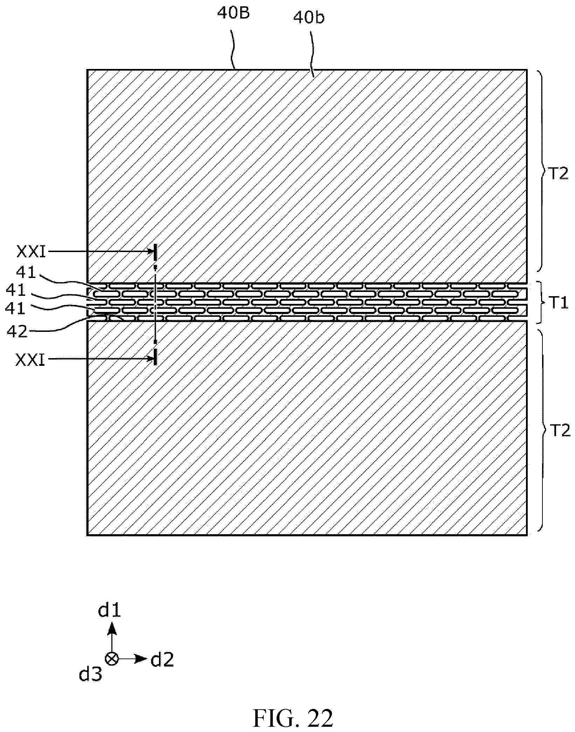

FIG. 20 is a top view of the back reinforcing member 40B forming a part of the display device 10B. FIG. 21 is an enlarged sectional view of the back reinforcing member 40B viewed from the side. FIG. 22 is a rear view of the back reinforcing member 40B. FIG. 21 shows a cross section taken along line XXI-XXI in FIG. 20.

The back reinforcing member 40B has a surface 40a facing the back face of the flexible display screen 25, and an inner face 40b facing away from the surface 40a. And, the back reinforcing member 40B include a first region portion T1 and a second region portion T2 adjacent to each other in the first direction d1 that is along the surface 40a.

In Embodiment 3, the first region portion T1 is configured to be located at the curved portion 15B of the display device 10B. The back reinforcing member 40B has one first region portion T1 and two second region portions T2. In the first direction d1, the one first region portion T1 is disposed between the two second region portions T2. In other words, in the first direction d1, the two second region portions T2 are provided outside the one first region portion T1. The length of the first region portion T1 in the first direction dl is shorter than the length of the second region portion T2.

Note that the first region portion T1 and the second region portion T2 are provided along the second direction d2, respectively. Each of the first region portion T1 and the second region portion T2 in the second direction d2 has the same length as the length of the back reinforcing member 40B in the second direction d2.

As shown in FIG. 21, one inner groove portion 42 and a plurality of through holes 41 are formed in the first region portion T1.

The inner groove portion 42 is formed to be recessed from the inner face 40b toward the surface 40a. The inner groove portion 42 is formed on the back reinforcing member 40B extending in the second direction d2 (see FIG. 22). The length of the inner groove portion 42 in the second direction d2 is the same as the length of the back reinforcing member 40B in the second direction d2.

The inner groove portion 42 has a side surface 42a extending from the inner face 40b toward the surface 40a, and a bottom surface 42b located more adjacent to the surface 40a than the inner portion 40b and connected to the side surface 42a. The depth from the inner face 40b to the bottom surface 42b is about half the thickness of the back reinforcing member 40B. The inner groove portion 42 is formed, for example, by half-etching a metal plate used as a material of the back reinforcing member 40B from the side where the inner face is located.

The plurality of through holes 41 are formed to pass through the surface 40a and the bottom surface 42b of the inner groove portion 42 in the first region portion T1, respectively.

As shown in FIGS. 20 and 22, the plurality of through holes 41 each have a long-hole shape having a width in the first direction d1 and a length in the second direction d2. The length of the through hole 41 in the second direction d2 is shorter than the length of the back reinforcing member 40B in the second direction d2. The through hole 41 may be rectangular in shape or may be elliptical in shape. The through hole 41 is formed by half-etching a metal plate serving as a material of the back reinforcing member 40B from two sides where the surface and the inner face are located.

When the back reinforcing member 40B is viewed from the third direction d3 perpendicular to the surface 40a, the plurality of through holes 41 are arranged in a staggered manner in the first region T1. In other words, when the plurality of through holes 41 are viewed from the first direction d1, adjacent two through holes 41 in the first direction d1 are partially overlapped. The plurality of through holes 41 are arranged in a staggered manner, so that the distance between the thick metal portions continuous in the first direction d1 is shortened, and the first region portion T1 has flexibility.

As shown in FIG. 21, when the back reinforcing member 40B is viewed from the second direction d2, the plurality of through holes 41 pass through the back reinforcing member 40B in the third direction d3. In this example, five through holes 41 are formed in the first region portion T1 in the first direction d1.

As shown in FIG. 21, the length L1 of the bottom surface 42b of the inner groove portion 42 in the first direction d1 is longer than the length (the hole width) L41 of the through hole 41 in the first direction d1 (L1>L41). The length L1 is longer than the distance p41 between the two adjacent through holes 41 in the first direction d1 (L1>p41).

As shown in FIG. 21, a plurality of concave portions 46 are provided in the second region portion T2. A plurality of concave portions 46 are formed on the surface 40a of the back reinforcing member 40B.

The concave portion 46 has a side surface 46a extending from the surface 40a toward the inner face 40b, and a bottom surface 46b located more adjacent to the inner face 40b than the surface 40a and connected to the side surface 46a. The depth from the surface 40a to the bottom surface 46b is about half the thickness of the back reinforcing member 40B. The concave portion 46 is formed, for example, by half-etching a metal plate serving as a material of the back reinforcing member 40B from the side where the surface is located.

As shown in FIG. 20, the plurality of concave portions 46 each have a long-hole shape having a width in the first direction d1 and a length in the second direction d2. A portion of the region of the concave portion 46 is shown by using the shadow dots in Fig. 20. The length of the concave portion 46 in the second direction d2 is shorter than the length of the back reinforcing member 40B in the second direction d2. The concave portion 46 may be rectangular in shape or oval in shape. It should be noted that in the present embodiment, the concave portion 46 and the through hole 41 have the same long-hole shape with the width in the first direction d1 and the length in the second direction d2.

When the back reinforcing member 40B is viewed from the third direction d3, the plurality of concave portions 46 are arranged in a staggered manner in the second region T2. In other words, when the plurality of concave portions 46 are viewed from the first direction d1, two adjacent concave portions 46 in the first direction d1 are partially overlapped.

As shown in FIG. 21, when the back reinforcing member 40B is viewed from the second direction d2, the plurality of concave portions 46 are formed to be recessed from the surface 40a toward the inner face 40b of the back reinforcing member 40B. In this example, twenty-six concave portions 46 are formed in the second region portion T2 in the first direction d1. The distance p41 between the two adjacent through holes 41 in the first direction d1, the distance p46 between the two concave portions 46, and the distance p416 between the through holes 41 and the concave portions 46 are the same.

As shown in the present embodiment, by providing the concave portion 46 in the second region T2 of the back reinforcing member 40B, it is possible to prevent the adhesion between the flexible display screen 25 and the back reinforcing member 40B from being reduced. Further, by providing the concave portion 46 in the second region portion T2, deterioration of the appearance of the display device 10B can be suppressed.

Further, in the present embodiment, the first region portion T1 is provided with an inner groove portion 42 recessed from the inner face 40b toward the surface 40a, and the length L1 of the bottom surface 42b of the inner groove portion 42 in the first direction d1 is longer than the length L41 of the through hole 41 in the first direction d1.

Accordingly, for example, when the metal plate serving as the material of the back reinforcing member 40B is half-etched from two sides where the surface and the inner face are located, the through hole 41 and the inner groove portion 42 may be connected even if the through hole 41 and the inner groove portion 42 are slightly staggered in the first direction d1. As a result, the softness of the back reinforcing member 40B in the first region portion T1 can be ensured.

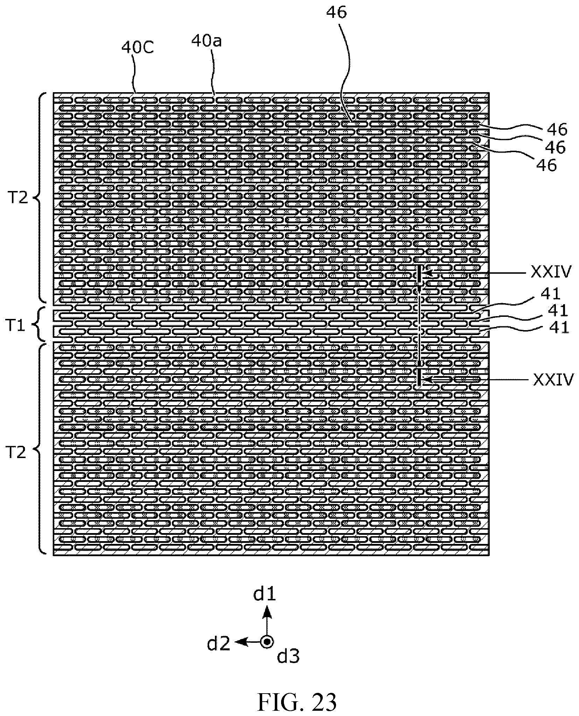

(Embodiment 4) The configuration of the display device 10C according to Embodiment 4 will be described with reference to FIGS. 23 to 25. In Embodiment 4, an example in which a through hole 41 is provided in the first region portion T1 and an inner groove portion 42 is not provided in the device structure of Embodiment 3 will be described.

The display device 10C includes a display panel 20, a back reinforcing member 40C, and a frame 70.

The display panel 20 is connected to the PCB 84 as a driving substrate through the COF 83 as a flexible substrate, and is driven by the PCB 84 to display an image.

The display panel 20 includes a circular polarizer 23 and a flexible display screen 25 attached to the back face of the circular polarizer 23. The circular polarizer 23 and the flexible display screen 25 are joined by an optical clear adhesive 24.

The back reinforcing member 40C is attached to the back face of the display panel 20, that is, the back face of the flexible display screen 25. The flexible display screen 25 and the back reinforcing member 40C are joined by an optical clear adhesive 30. The back reinforcing member 40C has flexibility and elasticity, and can be bent and deformed by application of an external force. A material such as stainless steel or Invar steel may be used as the material of the back reinforcing member 40C. The thickness of the back reinforcing member 40C may be appropriately selected from a range of, for example, 0.1 mm or more and 0.3 mm or less.

The frame 70 is attached to the back reinforcing member 40C by an adhesive 75. The frame 70 includes a first frame portion 71, a second frame portion 72, and a hinge 73. The first frame portion 71 is connected to a part of the back reinforcing member 40C, and the second frame portion 72 is connected to another part of the back reinforcing member 40C.

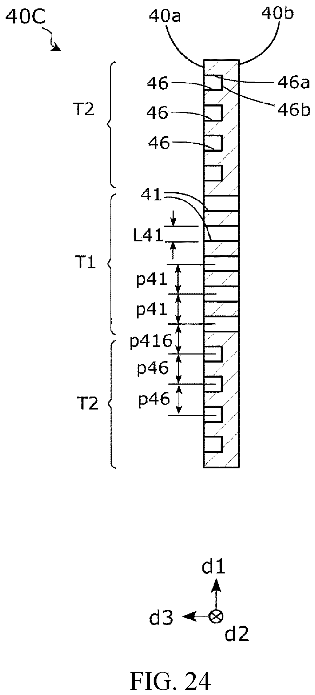

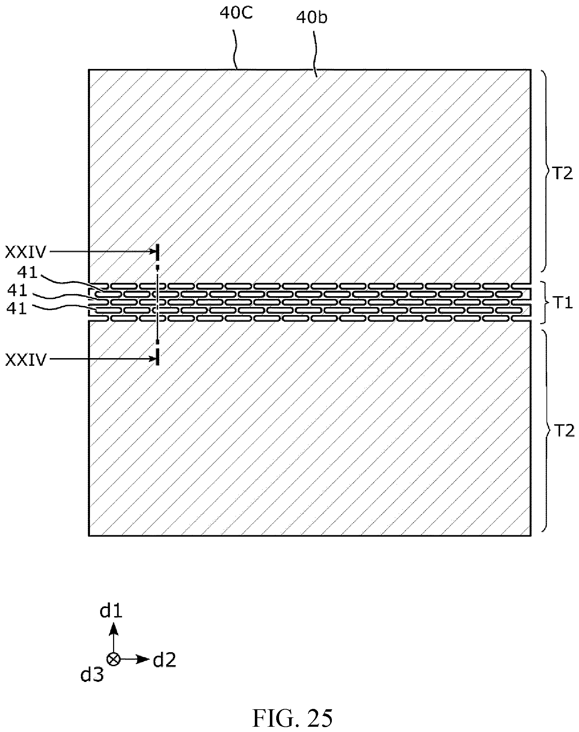

FIG. 23 is a top view of the back reinforcing member 40C forming a part of the display device 10C. FIG. 24 is an enlarged sectional view of the back reinforcing member 40C viewed from the side. FIG. 25 is a rear view of the back reinforcing member 40C. FIG. 24 shows a cross section taken along line XXIV-XXIV in FIG. 23.

The back reinforcing member 40C has a surface 40a facing toward the back face of the flexible display screen 25, and an inner face 40b facing away from the surface 40a. And, the back reinforcing member 40C has a first region portion T1 and a second region portion T2 adjacent to each other in a first direction d1 that is along the surface 40a.

In Embodiment 4, the first region portion T1 is configured to be located at the curved portion 15C of the display device 10C (see FIG. 17). The back reinforcing member 40C has one first region portion T1 and two second region portions T2. In the first direction d1, the one first region portion T1 is disposed between the two second region portions T2. In other words, in the first direction d1, the two second region portions T2 are provided outside the one first region portion T1. The length of the first region portion T1 in the first direction dl is shorter than the length of the second region portion T2.

Note that the first region portion T1 and the second region portion T2 are provided along the second direction d2, respectively. The length of each of the first region portion T1 and the second region portion T2 in the second direction d2 is the same as the length of the back reinforcing member 40C in the second direction d2.

As shown in FIG. 24, a plurality of through holes 41 are formed in the first region portion T1.

The plurality of through holes 41 are formed to pass through the surface 40a and the inner face 40b in the first region portion T1, respectively.

As shown in FIGS. 23 and 25, the plurality of through holes 41 each have a long-hole shape having a width in the first direction d1 and a length in the second direction d2. The length of the through hole 41 in the second direction d2 is shorter than the length of the back reinforcing member 40C in the second direction d2. The through hole 41 may be rectangular in shape or may be elliptical in shape. The through hole 41 is formed by half-etching a metal plate serving as a material of the back reinforcing member 40C from two sides where the surface and the inner face are located.

When the back reinforcing member 40C is viewed from the third direction d3 perpendicular to the surface 40a, the plurality of through holes 41 are arranged in a staggered manner in the first region portion T1. In other words, when the plurality of through holes 41 are viewed from the first direction d1, adjacent two through holes 41 in the first direction d1 are partially overlapped. The plurality of through holes 41 are arranged in a staggered manner, so that the distance between the continuous thick metal portions in the first direction d1 is shortened, and the first region portion T1 has flexibility.

As shown in FIG. 24, when the back reinforcing member 40C is viewed from the second direction d2, the plurality of through holes 41 pass through the back reinforcing member 40C in the third direction d3. In this example, five through holes 41 are formed in the first region portion T1 in the first direction d1.

As shown in FIG. 24, a plurality of concave portions 46 are provided in the second region portion T2. A plurality of concave portions 46 are formed on the surface 40a of the back reinforcing member 40C.

The concave portion 46 has a side surface 46a extending from the surface 40a toward the inner face 40b, and a bottom surface 46b located more adjacent to the inner face 40b than the surface 40a and connected to the side surface 46a. The depth from the surface 40a to the bottom surface 46b is approximately half the thickness of the back reinforcing member 40C. The concave portion 46 is formed, for example, by half-etching a metal plate serving as a material of the back reinforcing member 40C from the side where the surface is located.

As shown in FIG. 23, the plurality of concave portions 46 each have a long-hole shape having a width in the first direction d1 and a length in the second direction d2. FIG. 23 shows a portion of the region of the concave portion 46 by using shadow dots. The length of the concave portion 46 in the second direction d2 is shorter than the length of the back reinforcing member 40C in the second direction d2. The concave portion 46 may be rectangular in shape or oval in shape. It should be noted that in the present embodiment, the concave portion 46 and the through hole 41 have the same long-hole shape with the width in the first direction d1 and the length in the second direction d2.

When the back reinforcing member 40C is viewed from the third direction d3, the plurality of concave portions 46 are arranged in a staggered manner in the second region portion T2. In other words, when the plurality of concave portions 46 are viewed from the first direction d1, two adjacent concave portions 46 in the first direction d1 are partially overlapped.

As shown in FIG. 24, when the back reinforcing member 40C is viewed from the second direction d2, the plurality of concave portions 46 are formed to be recessed from the surface 40a toward the inner face 40b of the back reinforcing member 40C. In this example, twenty-six concave portions 46 are formed in the second region portion T2 in the first direction d1. The distance p41 between the two adjacent through holes 41 in the first direction d1, the distance p46 between the two concave portions 46, and the distance p416 between the through holes 41 and the concave portions 46 are the same.

As shown in the present embodiment, by providing the concave portion 46 in the second region T2 of the back reinforcing member 40C, it is possible to prevent the adhesion between the flexible display screen 25 and the back reinforcing member 40C from being reduced. Further, by providing the concave portion 46 in the second region portion T2, deterioration of the appearance of the display device 10C can be suppressed.

Further, in Embodiment 4, since the inner groove portion 42 is not formed, the hardness of the back reinforcing member 40C in the first region portion T1 can be improved as compared with Embodiment 3.

Accordingly, the structure of a display device or the like according to an embodiment of the present application is exemplified below.

[Example 1] A display device 10 (or a display device 10A, a display device 10B, and a display device 10C as described below) according to an embodiment of the present application includes a flexible display screen 25, and a plate-shaped back reinforcing member 40 (or a back reinforcing member 40A, a back reinforcing member 40B, and a back reinforcing member 40C as described below) attached to the back face of the flexible display screen 25. The back reinforcing member 40 has a surface 40a facing the back face of the flexible display screen 25, and an inner face 40b facing away from the surface 40a, and has a first region portion T1 and a second region portion T2 adjacent to each other in a first direction d1 that is along the surface 40a. When the back reinforcing member 40 is viewed from the second direction d2 that is along the surface 40a and perpendicular to the first direction d1, the first region portion T1 is provided with a through hole 41 through the back reinforcing member 40 in the third direction d3 perpendicular to both the first direction d1 and the second direction d2, and the second region portion T2 is provided with a concave portion 46 recessed from the surface 40a toward the inner face 40b.

Thus, when the back reinforcing member 40 is attached to the flexible display screen 25 by the optical clear adhesive by providing the concave portion 46 in the second region T2 of the back reinforcing member 40, a portion of the optical clear adhesive can be brought into contact with the inner face of the concave portion 46. As a result, it is possible to prevent the adhesion of the flexible display screen 25 and the back reinforcing member 40 from being reduced. Further, by providing the concave portion 46 in the second region portion T2, the degree of curvature in the second region portion T2 can be made close to the degree of curvature in the first region portion T1, and deterioration of the appearance of the display device 10 can be suppressed.

[Example 2] When the back reinforcing member 40 is viewed from the second direction d2, the multiple through holes 41 and the multiple concave portions 46 are provided in the first direction d1, respectively. The distance p41 between the two adjacent through holes 41 in the first direction d1, the distance p46 between the two concave portions 46, and the distance p416 between the through holes 41 and the concave portions 46 are the same.

Thus, by making the distance p41, the distance p46, and the distance p416 equal, the through holes 41 and the concave portions 46 can be regularly arranged. As a result, deterioration of the appearance of the display device 10 can be suppressed. The structure in Example 2 can be applied to Example 1.

[Example 3] When the back reinforcing member 40 is viewed from the third direction d3, the plurality of through holes 41 are arranged in a staggered manner in the first region portion T1, and the plurality of concave portions 46 are arranged in a staggered manner in the second region portion T2.

Thus, by arranging the plurality of through holes 41 and the plurality of concave portions 46 in a staggered manner, the back reinforcing member 40 is made flexible. As a result, deterioration of the appearance of the display device 10 can be suppressed. The structure in Example 3 can be applied to Example 1 or Example 2.

[Example 4] The through hole 41 and the concave portion 46 have the same long-hole shape with the width in the first direction d1 and the length in the second direction d2.

In this way, the through holes 41 and the concave portions 46 can be arranged regularly by making the through holes 41 and the concave portions 46 have the same long-hole shape. As a result, deterioration of the appearance of the display device 10 can be suppressed. The structure in Example 4 can be applied to any one of Examples 1 to 3.

[Example 5] The inner groove portion 42 recessed from the inner face 40b toward the surface 40a is provided in the first region portion T1. The inner groove portion 42 is formed in the second direction d2. The through hole 41 is formed to pass through the surface 40a in the first region portion T1 and the bottom surface 42b of the inner groove portion 42.

Thus, by providing the inner groove portions 42 in the first region portion T1, the flexibility of the back reinforcing member 40 in the first region portion T1 can be improved. The structure in Example 5 can be applied to any one of Examples 1 to 4.

[Example 6] The length L1 of the bottom surface 42b of the inner groove portion 42 in the first direction d1 is longer than the length L41 of the through hole 41 in the first direction d1.

Accordingly, when the metal plate serving as the material of the back reinforcing member 40 is half-etched from two sides where the surface and the inner face are located, the through hole 41 and the inner groove portion 42 can be connected even when the through hole 41 and the inner groove portion 42 are slightly staggered in the first direction d1. As a result, it is possible to prevent the hole that should be penetrated in the first region portion T1 from becoming non-penetrable, and to ensure the flexibility of the back reinforcing member 40 in the first region portion T1. The structure in Example 6 can be applied to Example 5.

[Example 7] The through holes 41 are formed to pass through the surface 40a and the inner face 40b in the first region portion T1.

Accordingly, the thick wall of the region other than the through holes 41 in the first region portion T1 can be made thicker. As a result, the hardness of the back reinforcing member 40A in the first region portion T1 can be improved. The structure in Example 7 can be applied to any one of Examples 1 to 4.

[Example 8] The first region portion T1 and the second region portion T2 are provided with a plurality of back reinforcing members 40 arranged alternately in the first direction d1.

Accordingly, the first region portion T1 and the second region portion T2 may be regularly arranged. As a result, deterioration of the appearance of the display device 10 can be suppressed. The structure in Example 8 can be applied to any one of Examples 1 to 7.

[Example 9] The back reinforcing member 40B (or the back reinforcing member 40C) has one first region portion T1 and two second region portions T2. In the first direction d1, the first region portion T1 is disposed between the two second region portions T2.

Accordingly, the folding device can be realized by using one first region portion T1 as the curved portion 15B (or the curved portion 15C) so that the two second region portions T2 can be opened and closed. The structure in Example 9 can be applied to any one of Examples 1 to 7.

[Example 10] The display device further includes a circular polarizer 23 that attached to the surface 40a facing the back face of the flexible display screen 25, and a back cover 60 that attached to the inner face of the back reinforcing member 40.

Accordingly, a display device may be provided, including a display panel 20 having a circular polarizer 23 and a flexible display screen, a back reinforcing member 40, and a back cover 60. The structure in Example 10 can be applied to any one of Examples 1 to 9.

[Example 11] A manufacturing method of a display device according to an embodiment of the present application is a manufacturing method of a display device including a flexible display screen 25 and a plate-shaped back reinforcing member 40 which is attached to the back face of the flexible display screen 25. The method includes a step of forming a back reinforcing member 40 having first region portion(s) T1 and second region portion(s) T2 which are adjacent to each other in a first direction d1 that is along a surface 90a of the metal plate 90 by etching the metal plate 90; a step of attaching the flexible display screen 25 and the back reinforcing member 40. The step of forming the back reinforcing member 40 includes a plurality of through holes 41 are formed in the first region portion(s) T1 by half-etching the surface 90a and the inner face 90b of the metal plate 90, respectively, and a plurality of concave portions 46 are formed in the second region portion(s) T2 by half-etching the surface 90a of the metal plate 90.

According to this manufacturing method, it is possible to manufacture the display device 10 capable of suppressing the decrease in the adhesion between the flexible display screen 25 and the back reinforcing member 40. Further, the display device 10 can be manufactured to suppress deterioration of appearance.

(Other embodiments) While the above-described display device related to the present application have been described by using the embodiments, the above-described embodiments of the present application are not limited thereto. Without departing from the scope of the core idea of the present application, variations obtained by those skilled in the art through various modifications based on the above embodiments, as well as various devices containing display panels related to the present application, also fall within the protection scope of the present application.

In the above [Example 1], the configuration of the first region portion T1 and the second region portion T2 is described in the case where the back reinforcing member 40 is viewed in the second direction d2, but the configuration of the first region portion T1 and the second region portion T2 may not be limited to the configuration where the back reinforcing member 40 is viewed in the case where the back reinforcing member 40 is viewed in section along the second direction d2. That is, the display device 10 may include a flexible display screen 25, and a plate-shaped back reinforcing member 40 connected to the back face of the flexible display screen 25. The back reinforcing member 40 has a surface 40a facing the back face of the flexible display screen 25, and an inner face 40b facing away from the surface 40a. The back reinforcing member has a first region portion T1 and a second region portion T2 adjacent to each other in a first direction d1 that is along the surface 40a. In the first region portion T1, a through hole 41 penetrating through the back reinforcing member 40 is provided in a third direction d3 perpendicular to both the first direction d1 and the second direction d2. A concave portion 46 recessed from the surface 40a toward the inner face 40b is provided in the second region portion T2.

### Industrial utilization possibility

The related display device of the present application can be used for a digital television, a digital sign, a smartphone, a tablet terminal, or a wearable terminal.

## Claims

1. A display device (10, 10A, 10B, 10C) comprising a flexible display screen (25) and a plate-shaped back reinforcing member (40, 40A, 40B, 40C) attached to a back face of the flexible display screen,
wherein the back reinforcing member comprises a surface (40a) facing towards the back face of the flexible display screen and an inner face (40b) facing away from the surface, and the back reinforcing member comprises one or more first region portions (T1) and one or more second region portions (T2) that are adjacent to each other in a first direction (d1) that is along the surface,
when the back reinforcing member is viewed in section in a second direction (d2) that is along the surface (40a) and perpendicular to the first direction (d1), one or more through holes (41) through the back reinforcing member are provided in the one or more first region portions in a third direction (d3) perpendicular to both the first direction and the second direction, and one or more concave portions (46) recessed from the surface (40a) toward the inner face (40b) are provided in the one or more second region portions (T2).

2. The display device according to claim 1, wherein when the back reinforcing member is viewed in section in the second direction, the one or more through holes comprise a plurality of through holes along the first direction, and the one or more concave portions comprise a plurality of concave portions along the first direction, a distance (p41) between adjacent two of the plurality of through holes in the first direction, a distance (p46) between two of the plurality of concave portions, and a distance (p416) between each of ones of the plurality of through holes and an adjacent one of the plurality of concave portions are the same.

3. The display device according to claim 1, wherein the one or more through holes (41) comprise a plurality of through holes, and the one or more concave portions (46) comprise a plurality of concave portions, when the back reinforcing member is viewed from the third direction, ones of the plurality of the through holes are arranged staggeredly in each of the one or more first region portions, and ones of the plurality of the concave portions are arranged staggeredly in each of the one or more second region portions.

4. The display device according to any one of claims 1 to 3, wherein the one or more through holes and the one or more concave portions have same long-hole shapes each having a width in the first direction (d1) and a length in the second direction (d2).

5. The display device according to any one of claims 1 to 4, wherein the one or more first region portions are provided with inner groove portions (42) recessed from the inner face toward the surface, the inner groove portions are formed in the second direction, and the one or more through holes are formed to penetrate through the surface in the one or more first region portions and bottom surfaces (42b) of the inner groove portions (42).

6. The display device according to claim 5, wherein lengths of the bottom surfaces (42b) of the inner groove portions (42) in the first direction are longer than lengths of the one or more through holes in the first direction.

7. The display device according to any one of claims 1 to 6, wherein the one or more through holes are formed to penetrate through the surface and the inner face in the one or more first region portions.

8. The display device according to any one of claims 1 to 7, wherein the one or more first region portions comprise a plurality of first region portions and the one or more second region portions comprise a plurality of second region portions, and the plurality of first region portions and the plurality of second region portions are arranged alternately in the first direction.

9. The display device according to any one of claims 1 to 8, wherein the back reinforcing member comprises one of the one or more first region portions and two of the one or more second region portions, and the one first region portion is disposed between the two second region portions in the first direction.

10. The display device according to any one of claims 1 to 9, further comprising a circular polarizer (23) attached to the surface (40a) of the back reinforcing member , and a back cover (60) attached to the inner face (40b) of the back reinforcing member.

11. A manufacturing method for a display device (10, 10A, 10B, 10C) comprising a flexible display screen (25) and a plate-shaped back reinforcing member (40, 40A, 40B, 40C) attached to a back face of the flexible display screen, the manufacturing method comprising:
a step of forming the back reinforcing member comprising one or more first region portions (T1) and one or more second region portions (T2) adjacent to each other in a first direction that is along a surface of a metal plate by etching the metal plate; a step of attaching the flexible display screen and the back reinforcing member;
wherein the step of forming the back reinforcing member comprises: forming a plurality of through holes (41) in the one or more first region portions by half-etching the surface and an inner face of the metal plate, respectively, and forming a plurality of concave portions (46) in the one or more second region portions by half-etching the surface of the metal plate.
